# EUROPEAN PATENT SPECIFICATION

(11) **EP 3 928 359 B1**
(45) Date of publication and mention of the grant of the patent: **18.06.2025**
(21) Application number: 20759380.7
(22) Date of filing: 18.02.2020
(51) Int. Cl.: H10N 60/01, H10N 60/20

(54) **SUPERCONDUCTOR WIRE AND FABRICATION THEREOF**
SUPRALEITENDER DRAHT UND HERSTELLUNG DESSELBEN
FIL SUPRACONDUCTEUR ET FABRICATION DUQUEL

(30) Priority: 18.02.2019 US 201962807133 P
(43) Date of publication of application: 29.12.2021
(73) Proprietor: Superpower, Inc., Schenectady, NY 12304 (US)
(72) Inventor: FUKUSHIMA, Toru, Schenectady, NY 12304 (US); YASUNAGA, Shinya, Schenectady, NY 12304 (US)
(74) Representative: Zimmermann & Partner Patentanwälte mbB
(86) International application number: PCT/US2020/018708
(87) International publication number: WO 2020/172201

(56) References cited:
- WO-A1-2016/024528
- US-A1- 2007 179 063
- US-A1- 2007 179 063
- US-A1- 2012 211 475
- US-A1- 2013 137 579
- US-A1- 2015 087 524
- US-A1- 2016 111 188
- US-A1- 2016 111 188
- US-B2- 8 926 868

## Description

### TECHNICAL FIELD OF THE INVENTION

The present invention is directed to high temperature superconducting wire, and in particular to a structure and fabrication method that reduces damage resulting from mechanical slitting.

### BACKGROUND OF THE INVENTION

The potential for high temperature superconductors (HTS) to efficiently transmit, generate, transform, use, and store electrical energy is recognized. In particular, more efficient electric power systems depend on more efficient wire technology. Past advancements permit brittle HTS materials to be formed into kilometer-length wires capable of transmitting about two hundred times the current than conventional copper and aluminum conductors of the same physical dimensions. The term "wire" is used herein to refer to any elongated configuration including tapes or strips.

Recent research in HTS materials provides potential for the economically feasible use of such materials in the power industry, including applications for power generation, transmission, distribution, and storage. The use of HTS devices in the power industry would result in significant reduction in the size (i.e., footprint) of electric power equipment, reduced environmental impact, greater safety, and increased capacity over conventional technology.

Two generations of HTS wire materials have been explored previously. The first generation (hereinafter "1G") of HTS wires included the use of BSCCO high-Tc superconductor, typically embedded in a matrix of noble metal (e.g. Ag). Without limitation, 1G wires are fabricated by a thermo-mechanical process wherein the superconducting powder is packed into silver billets that are drawn, rolled, and heat-treated to form the wire. The drawbacks of 1G wires are the high materials costs (e.g. Ag), elaborate processing operations, and generally poor critical current performance in high magnetic fields at high temperatures, which limit the lengths of the wires.

More recently, rare earth-based HTS materials ((RE)BCO) have been used in second generation (hereinafter "2G) HTS wires. Rare earth elements include, but are not limited to, Yttrium, Samarium and Gadolinium. 2G HTS wire processing typically involves thin film deposition of a multilayer stack on nickel alloy tapes. In order to achieve high critical currents, the maximal current of a superconductor, the superconducting film is grown epitaxially in a single crystalline-like form on oxide buffer layers that provide a single crystalline-like template even when deposited on polycrystalline metal substrate. In certain instances, 2G HTS tape utilizes YBCO coated conductors. 2G conductor (or wire) offers both performance benefits (operates at higher temperatures and background magnetic fields) and cost benefits.

Recently, the focus of the HTS industry has been to increase current carrying capacity, throughput of wire production, and decrease manufacturing cost. The objective is to fabricate commercially viable, high performance HTS wire that is available to the power industry to build devices, such as transmission cables and transformers, for the power grid.

As described in more detail below, one method of manufacturing 2G HTS wire involves a combination of electroplating, sputtering, and metal-organic chemical vapor deposition (MOCVD) steps to deposit buffer layers, a superconductor layer, and one or more cap layers onto a substrate. It is often more cost-effective to manufacture HTS wires with relatively large widths (for example, from 12 mm up to as much as 10 cm or more) as a base conductor. The wires can then be slit along their lengths to produce multiple wires having a smaller width. The desired width of a conductor wire is driven by the specific application. For HTS cables, a width of about 4 mm is often preferred, while other applications, such as am HTS transformer low voltage winding, may require a wide tape to accommodate high operating currents. HTS wire manufactured with greater widths can be slit to a desired width, usually before the final application of a cap layer or stabilizer. For example, a 12 mm HTS wire could be slit to produce two 6 mm HTS wires, three 4 mm HTS wires, four 3 mm HTS wires, six 2 mm HTS wires or even one 8 mm and one 4 mm HTS wires.

Slitting the HTS base conductor can be accomplished using a variety of known methods, including using a laser slitter or a mechanical slitter that slices the HTS base conductor using metal blades. Mechanical slitters have a lower cost and higher throughput than many other types of slitters. Unfortunately, however, the mechanical slitting process can cause damage to the relatively brittle superconducting and buffer layers. This damage can result in the formation of cracks that can spread, degrading the mechanical and electrical properties of the wire and ultimately causing delamination of the wire and critical current (Ic) deterioration. Examples of prior art may be found in document US 2007/179063 A1.

What is needed is an improvement to reduce or eliminate damage to the superconducting wire caused by mechanical slitting.

### SUMMARY OF THE INVENTION

According to embodiments of the present invention, a 2nd generation high temperature superconductor wire is provided that prevents mechanical destruction from the wire edge due to slitting. A 2G HTS wire according to embodiments of the present invention has a structure that prevents mechanical destruction from the wire edge. This can be accomplished by forming a striation at or near the edge of the wire where the buffer and superconducting layers are removed to prevent any propagation of edge cracks from damaging the HTS wire.

The foregoing has outlined rather broadly the features and technical advantages of the present invention in order that the detailed description of the invention that follows may be better understood. Additional features and advantages of the invention will be described hereinafter. It should be appreciated by those skilled in the art that the conception and specific embodiments disclosed may be readily utilized as a basis for modifying or designing other structures for carrying out the same purposes of the present invention. The invention is defined by the appended claims.

### BRIEF DESCRIPTION OF THE DRAWINGS

For a more thorough understanding of the present invention, and advantages thereof, reference is now made to the following descriptions taken in conjunction with the accompanying drawings, in which:
FIG. 1 illustrates an HTS conductive tape according to an embodiment of the present invention.
FIG. 2 illustrates a cross-section of an HTS tape according to another embodiment of the present invention in which the entire superconductive tape is encapsulated by electroplated stabilizer.
FIG. 3 is a schematic illustration of the process of slitting a base conductor of 2G HTS wire using a mechanical splitter.
FIG. 4 is a micrograph showing a magnified image of the edge of an HTS wire after slitting.
FIG. 5A shows a cross section of a multilayer HTS wire according to an embodiment of the invention.
FIG. 5B is a top down view of a multilayer HTS wire according to an embodiment of the invention.
FIG. 6 shows a cross section of one of the two narrower HTS wires produced by the slitting shown in FIG. 5.
FIG. 7 shows the cross section of FIG. 7 after another capping layer has been applied according to an embodiment of the invention.
FIG. 8 is a micrograph of an HTS wire where a striation has been formed before slitting according to an embodiment of the invention.
FIG. 9 shows another embodiment of the present invention in which four separate striations are formed so that the base HTS wire will be separated into three narrower final HTS wires.
FIG.10 shows another embodiment of the present invention in which a single striation is formed (for each desired slit) and then the HTS wire is slit within the striation.
FIG. 11 shows a cross section of a single multilayer HTS wire after slitting according to the embodiment of FIG. 10.
FIGS. 12A-12C show different striation shapes formed according to embodiments of the invention.
FIG. 13 is a schematic illustration of a device for cutting striations and mechanically splitting the base HTS wire according to an embodiment.

The accompanying drawings are not intended to be drawn to scale. In the drawings, each identical or nearly identical component that is illustrated in various figures is represented by a like numeral. For purposes of clarity, not every component may be labeled in every drawing.

### DETAILED DESCRIPTION OF PREFERRED EMBODIMENTS

Embodiments of the present invention include a 2nd generation high temperature superconductor wire that prevents mechanical destruction from the wire edge due to slitting. A 2G HTS wire according to embodiments of the present invention has a structure that prevents mechanical destruction from the wire edge. This can be accomplished by forming a striation at or near the edge of the wire where the buffer and superconducting layers are removed to prevent any propagation of edge cracks from damaging the HTS wire.

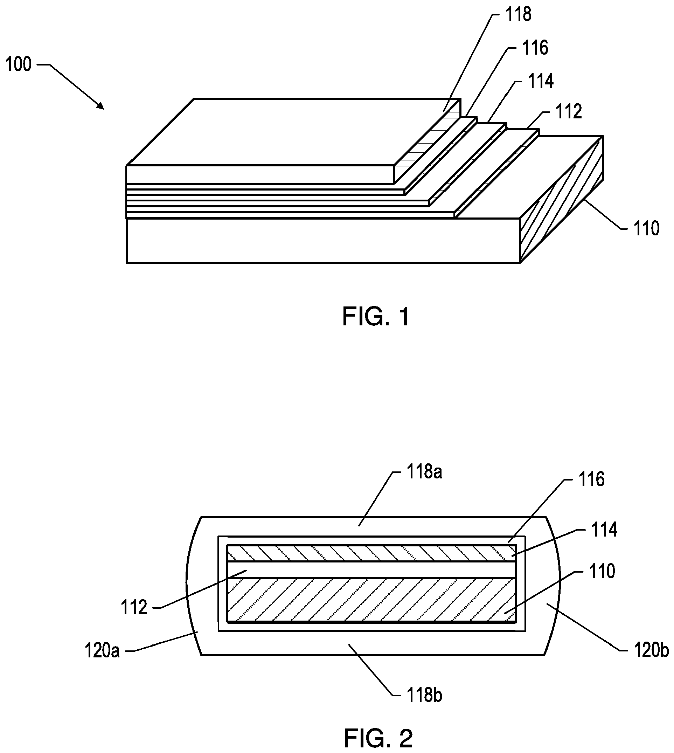

A schematic of a typical 2G HTS wire 100 is shown in FIG. 1. The wire includes a substrate 110, a buffer layer 112 (which could include multiple buffer layers) overlying substrate 110, an HTS layer 114, followed by a capping layer 116 (typically a noble metal layer), and a stabilizer layer 118 (typically a non-noble metal). In the embodiment depicted in FIG. 1, buffer layer 112, HTS layer 114, capping layer 116 and stabilizer layer 118 are collectively referred to as the superconducting region, which as illustrated, is disposed along one main surface of substrate 110.

The substrate 110 is typically in a tape-like configuration, having a high aspect ratio. For example, the width of the tape is generally on the order of about 2-12 mm, and the length of the tape is typically at least about 100 m, most typically greater than about 500 m. Accordingly, the substrate may have an aspect ratio which is fairly high, on the order of not less than 10³, or even not less than 10⁴. Certain embodiments are longer, having an aspect ratio of 10⁵ and higher. As used herein, the term 'aspect ratio' is used to denote the ratio of the length of the substrate or tape to the next longest dimension, that is, the width of the substrate or tape.

In one embodiment, the substrate is treated so as to have desirable surface properties for subsequent deposition of the constituent layers of the HTS tape. For example, the surface may be lightly polished to a desired flatness and surface roughness. Additionally, the substrate may be treated to be biaxially textured as is understood in the art, such as by the known RABiTS (roll assisted biaxially textured substrate) technique.

Turning to buffer layer 111, the buffer layer may be a single layer, or more commonly, be made up of several films. Most typically, the buffer layer includes a biaxially textured film, having a crystalline texture that is generally aligned along crystal axes both inplane and out-of-plane of the film. Such biaxial texturing may be accomplished by IBAD. As is understood in the art, IBAD is an acronym for Ion Beam Assisted Deposition, a technique which may be advantageously utilized to form a suitably textured buffer layer for subsequent formation of an HTS layer having desirable crystallographic orientation for superior superconducting properties. Magnesium oxide is a typical material of choice for the IBAD film and may be on the order or 50 to 500 Angstroms, such as 50 to 200 Angstroms. Generally, the IBAD film has a rock-salt like crystal structure, as defined and described in U.S. Pat. No. 6,190,752.

The buffer layer may include additional films, such as a barrier film provided to directly contact and be placed in between an IBAD film and the substrate. In this regard, the barrier film may advantageously be formed of an oxide, such as yttria, and functions to isolate the substrate from the IBAD film. A barrier film may also be formed of non-oxides such as silicon nitride and silicon carbide. Suitable techniques for deposition of a barrier film include chemical vapor deposition and physical vapor deposition including sputtering. Typical thicknesses of the barrier film may be within a range of about 100-200 angstroms. Still further, the buffer layer may also include an epitaxially grown film, formed over the IBAD film. In this context, the epitaxially grown film is effective to increase the thickness of the IBAD film and may desirably be made principally of the same material utilized for the IBAD layer such as MgO.

In embodiments utilizing an MgO-based IBAD film and/or epitaxial film, a lattice mismatch between the MgO material and the material of the superconducting layer exists. Accordingly, the buffer layer may further include another buffer film, this one in particular implemented to reduce a mismatch in lattice constants between the HTS layer and the underlying IBAD film and/or epitaxial film. This buffer film may be formed of materials such as YSZ (yttria-stabilized zirconia) strontium ruthenate, lanthanum manganate, and generally, perovskite-structured ceramic materials. The buffer film may be deposited by various physical vapor deposition techniques.

While the foregoing has principally focused on implementation of a biaxially textured film in the buffer stack (layer) by a texturing process such as IBAD, alternatively, the substrate surface itself may be biaxially textured. In this case, the buffer layer is generally epitaxially grown on the textured substrate so as to preserve biaxial texturing in the buffer layer. One process for forming a biaxially textured substrate is the process known in the art as RABiTS (roll assisted biaxially textured substrates), generally understood in the art.

High-temperature superconductor (HTS) layer 112 is typically chosen from any of the high-temperature superconducting materials that exhibit superconducting properties above the temperature of liquid nitrogen, 77° K. Such materials may include, for example, YBa₂Cu₃O₇₋ₓ, Bi₂Sr₂Ca₂Cu₃O_{10+y}, Ti₂Ba₂Ca₂Cu₃O_{10+y}, and HgBa₂ Ca₂Cu₃ O_{8+y}. One class of materials includes REBa₂Cu₃O₇₋ₓ, wherein RE is a rare earth element. Of the foregoing, YBa₂Cu₃O₇₋ₓ, also generally referred to as YBCO, may be advantageously utilized. The HTS layer 112 may be formed by anyone of various techniques, including thick and thin film forming techniques. Preferably, a thin film physical vapor deposition technique such as pulsed laser deposition (PLD) can be used for a high deposition rates, or a chemical vapor deposition technique can be used for lower cost and larger surface area treatment. Typically, the HTS layer has a thickness on the order of about 1 to about 30 µm, most typically about 2 to about 20 µm, such as about 2 to about 10 µm, in order to get desirable amperage ratings associated with the HTS layer 114.

Capping layer 116 and stabilizer layer 118 are generally implemented for electrical stabilization, that is, to aid in prevention of HTS burnout in practical use. More particularly, layers 116 and 118 aid in continued flow of electrical charges along the HTS conductor in cases where cooling fails or the critical current density is exceeded, and the HTS layer moves from the superconducting state and becomes resistive. Typically, a noble metal is utilized for capping layer 116 to prevent unwanted interaction between the stabilizer layer(s) and the HTS layer 144. Typical noble metals include gold, silver, platinum, and palladium. Silver is typically used due to its cost and general accessibility. Capping layer 116 is typically made to be thick enough to prevent unwanted diffusion of the components from stabilizer layer 118 into HTS layer 114 but is made to be generally thin for cost reasons (raw material and processing costs). Typical thicknesses of capping layer 114 range within about 0.1 to about 10.0 µm, such as 0.5 to about 5.0 µm. Various techniques may be used for deposition of capping layer 116, including physical vapor deposition, such as DC magnetron sputtering.

Depending on the implementation, stabilizer layer 118 is incorporated to overlie the superconducting layer 114 and, in particular, overlie and directly contact capping layer 116 in the embodiment shown in FIG. 1. Stabilizer layer 118 functions as a protection/shunt layer to enhance stability against harsh environmental conditions and superconductivity quench. The layer is generally dense and thermally and electrically conductive, and functions to bypass electrical current in case of failure in the superconducting layer. Conventionally, such layers have been formed by laminating a pre-formed copper strip onto the superconducting tape, by using an intermediary bonding material such as a solder or flux. Other techniques have focused on physical vapor deposition, typically, sputtering. However, such application techniques are costly, and not particularly economically feasible for large-scale production operations. Stabilizer layer 118 can be formed by electroplating. According to this technique, electroplating can be used to quickly build-up a thick layer of material on the superconducting tape, and it is a relatively low-cost process that can effectively produce dense layers of thermally and electrically conductive metals. The stabilizer layer can be deposited without the use of or reliance upon and without the use of an intermediate bonding layer, such as a solder layer (including fluxes) that have a melting point less than about 300° C.

Electroplating (also known as electrodeposition) is generally performed by immersing the superconductive tape in a solution containing ions of the metal to be deposited. The surface of the tape is connected to an external power supply and current is passed through the surface into the solution, causing a reaction of metal ions (M^{z-}) with electrons (e⁻) to form a metal (M).

Capping layer 116 functions as a second layer for deposition of copper thereon. In the particular case of electroplating of stabilizer metals, the superconductive tape is generally immersed in a solution containing cupric ions, such as in a copper sulfate solution. Electrical contact is made to capping layer 116 and current is passed such that the reaction Cu²⁺+2e⁻→Cu occurs at the surface of the capping layer 116. The capping layer 114 functions as the cathode in the solution, such that the metal ions are reduced to Cu metal atoms and deposited on the tape. On the other hand, a copper-containing anode is placed in the solution, at which an oxidation reaction occurs such that copper ions go into solution for reduction and deposition at the cathode.

In the absence of any secondary reactions, the current delivered to the conductive surface during electroplating is directly proportional to the quantity of metal deposited (Faraday's Law of Electrolysis). Using this relationship, the mass, and hence thickness of the deposited material forming stabilizer layer 118 can be readily controlled.

While the foregoing generally references copper, it is noticed that other metals, including aluminum, silver, gold, and other thermally and electrically conductive metals may also be utilized. However, it is generally desirable to utilize a non-noble metal to reduce overall materials cost for forming the superconductive tape.

While the foregoing description and FIG. 1 describes electroplating to form stabilizer layer 116 along one side of the superconductive tape, it is also noted that the opposite, major side of the superconductive tape may also be coated, and indeed, the entirety of the structure can be coated so as to be encapsulated. Those skilled in the art will note that the above-description of HTS conductor 100 in FIG. 1 is provided by way of example only. The superconducting articles described hereinbelow may utilize any appropriate superconducting conductor.

FIG. 2 is a cross-sectional diagram illustrating another embodiment of the present invention, in which the entire superconductive tape is encapsulated with a capping stabilizer layer 118 comprising a first stabilizer layer 118a, second stabilizer layer 118b disposed on an opposite major surface of the superconductive tape, the first and second stabilizer layers 118a, 118b, joining together along the side surfaces of the superconductive tape, forming generally convex side portions or side bridges 120a and 120b. This particular structure is desirable to further improve current flow and further protect the HTS layer 114, in the case of cryogenic failure, superconductivity quench, etc. By essentially doubling the cross-sectional area of the deposited stabilizer layer by forming first and second stabilizer layers 118a and 118b, a marked improvement in current-carrying capability is provided. Electrical continuity between stabilizer layers 118a and 181b may be provided by the lateral bridging portions 120a and 120b. In this regard, the lateral bridging portions 120a and 120b may desirably have a positive radius of curvature so as to form generally convex surfaces, which may further reduce buildup of electrical charge at high voltages that HTS electric power devices will experience. Additionally, to the extent that a suitably electrically conductive material is utilized for the substrate 110, further current-carrying capability can be provided by encapsulation (fully surrounding the constituent layers of the article) as illustrated in FIG.2. That is, the bridging portions extending laterally and defining side surfaces of the tape may provide electrical connection to the substrate itself, which can add to the current carrying capability of the coated conductor (tape).

While embodiments of the present invention are particularly suitable for formation of a stabilizer layer that is continuous, having side bridges that are formed of the same material, other embodiments utilize a different material for the side bridges. For example, the lateral surfaces can be masked during stabilizer deposition, followed by mask removal and deposition of a different side bridge composition. Particularly suitable are high melting point solders, such as lead-tin compositions. Typically, such solders have a melting point greater than about 180 °C. Use of high melting point solders or use of a surround stabilizer (which also has a melting point greater than 180 °C) such as copper is of notable importance. Particularly, high melting point materials permit improved flexibility of conductor processing by the end user, due to greater temperature range in which the conductor can be manipulated, such as during joining operations.

While not shown in FIG. 2, it may be generally desirable to deposit a noble metal layer along the entirety of the superconductive tape, particularly along the side surfaces of the superconductive tape, to isolate the superconductor layer 114 from the material of the bridging portions 120a and 120b, which may be a non-noble metal such as copper or aluminum as described above.

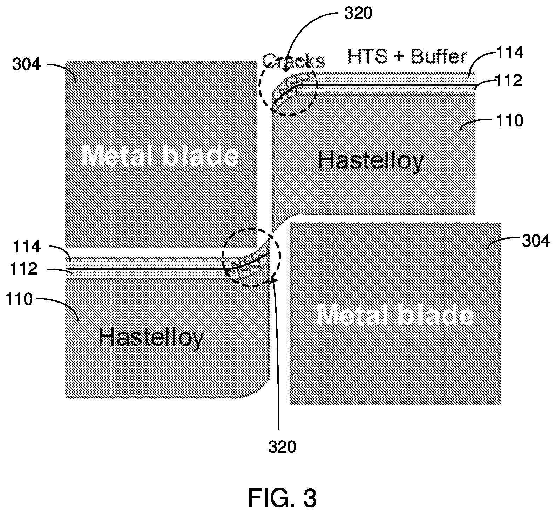

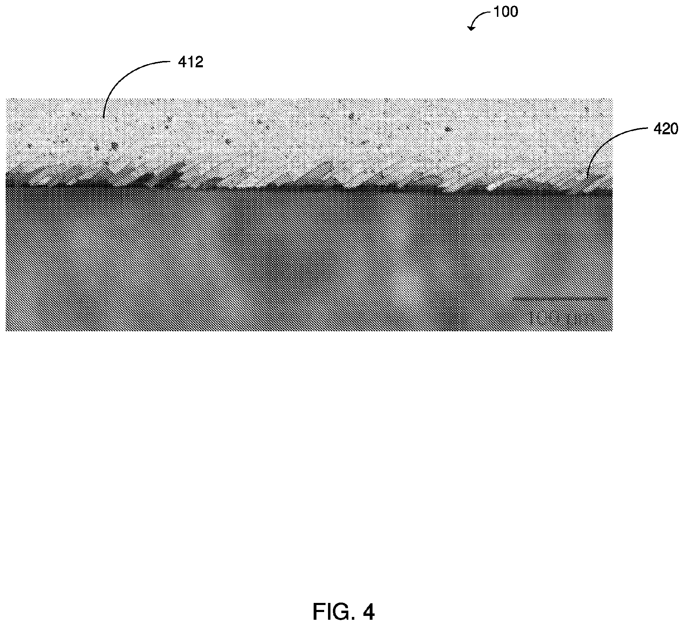

FIG. 3 is a schematic illustration of the process of slitting a base conductor of 2G HTS wire using a mechanical splitter. As described above, it is often more cost-effective to manufacture HTS wires with relatively large widths (for example, from 12 mm up to as much as 10 cm or more) as a base conductor. The wires can then be slit along their lengths to produce multiple wires having a smaller width. Using a mechanical splitter is highly desirable for reasons of both cost and throughput speed. As shown in FIG. 3, however, the mechanical shearing caused by the splitter blades 304 can damage the cut edges of the HTS wire in the region shown by dashed circle 320. Cracks in the relatively brittle HTS and buffer layers can propagate and spread far beyond the edge regions, causing wire swelling, layer delamination, and Ic deterioration. FIG. 4 is a micrograph showing a magnified image of the edge of an HTS wire 100 after slitting showing cracks 420 in the buffer and HTS layers 412 extending from the edge of the slit.

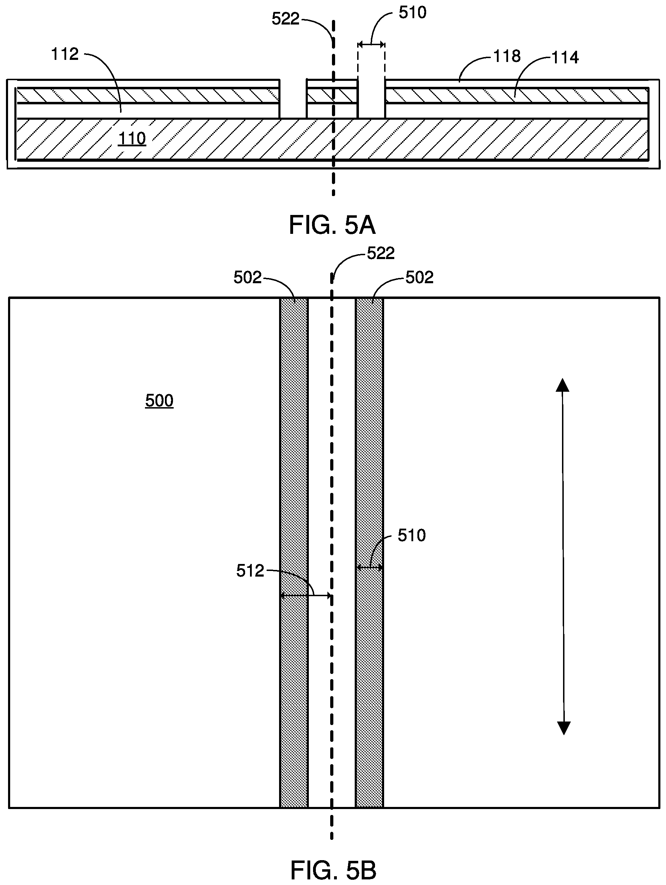

FIG. 5A shows a cross section of a multilayer HTS wire 500 according to an embodiment of the invention. Buffer layer 112 and HTS layer 114 are formed on substrate layer 110 as described above. An encapsulating capping layer (typically a noble metal such as silver) has been deposited over the entire structure. Referring also to FIG. 5B, two parallel striations 502 have been cut lengthwise into an HTS wire 500 base conductor removing the capping layer, the HTS layer, and the buffer layer. In some embodiments, the striations will be cut after the deposition of the encapsulating metal layer and just before slitting the original HTS wire to minimize any positional error. Although the striations can be formed before deposition of the encapsulating layer, the additional processing steps tend to introduce undesirable positioning error with respect to the position of the slit relative to the striation. In some embodiments, an additional capping layer is deposited after cutting the striations and before slitting. This second layer (deposited over the striations) serves to cover the edges of the HTS and buffer layers to provide mechanical support and protect those layers from exposure to the atmosphere or contaminants. By depositing only a thin second layer, positional defects are reduced. After the striations have been cut, the HTS wire can be mechanically slit along line 522 to form two HTS wires having narrower widths.

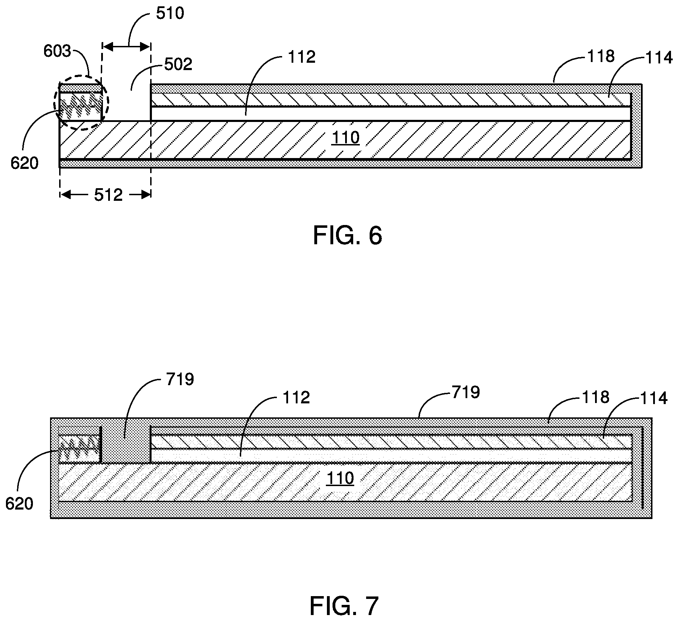

FIG. 6 shows a cross section of one of the two narrower HTS wires produced by the slitting shown in FIG. 5B. Damage such as cracks 620 have formed in the area indicated by dashed circle 603. While the damage has propagated throughout region 603, because the brittle buffer and HTS layers have been removed by forming striation 502, the cracks cannot propagate into the bulk of the HTS and buffer layers in the rest of the HTS wire.

In the embodiment shown in FIG. 7, another thin encapsulating capping layer 719 has been applied to the HTS wire, which has filled in the striation 502 with the capping material (such as silver) which covers the edges of the HTS and buffer layers exposed during formation of the striation to provide mechanical protection for these layers and to protect the superconducting layer from chemicals in the subsequent metal plating process. In some embodiments, an encapsulating stabilizer layer can then be applied over the entire HTS wire as described above.

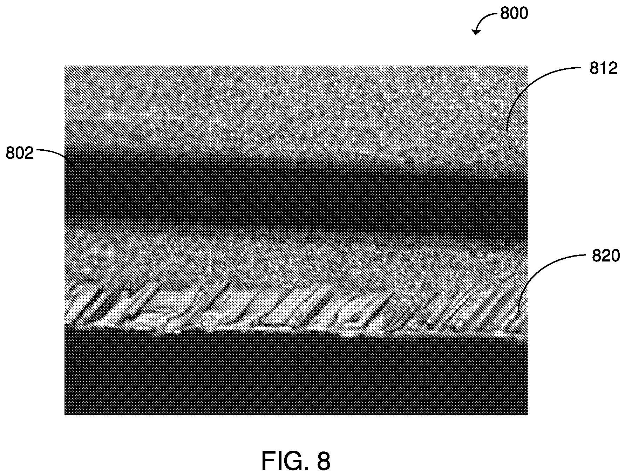

FIG. 8 is a micrograph of an HTS wire 800 where a striation 802 has been formed before slitting. As shown in FIG. 8, the cracks 820 in the HTS and buffer layers 812 caused by the mechanical slitting are evident along the cut edge of the HTS wire. None of the damage, however, has spread beyond the striation 802.

According to embodiments of the invention, striations to block the propagation of edge damage can be formed in a variety of ways, including without limitation laser ablation, etching, or ion beam or plasma milling. For example, in some embodiments, a striation can be formed using a Femto-second pulse laser to remove material in the desired location. In other embodiments, the striations can be formed by patterning the buffer and superconducting layers during deposition so that no buffer or superconductor is deposited within the striations.

In order to fully prevent cracks from propagating across both the buffer and HTS layers, it is desirable that all or substantially all of the buffer and HTS material in the striation be removed. In some cases, the striation may extend into the substrate layer. In some embodiments, the striation width will be at least 10 µm wide, such as at least 20 µm wide, at least 30 µm wide, at least 40 µm wide, at least 50 µm wide, at least 100 µm wide, or at least 500 µm wide. Because the striation process makes a portion of the original HTS wire unusable, it is desirable to make the striations as narrow as possible while still preventing damage propagation resulting from slitting. Forming a narrow striation using, for example, laser ablation or particle beam milling is also generally easier and faster than forming a wide striation.

In some embodiments, a striation would be formed on either side of the desired location of a mechanical slit as shown in FIGS. 5A and 5B. Referring also to FIG. 6, each striation can be positioned so that the distance 512 between the edge of the effective HTS layer (the edge formed by the striation) and the slit edge of the HTS wire is 500 µm or less, such as 200 µm or less, 100 µm or less, or 50 µm or less. In some embodiments, each striation can be positioned so that the distance 510 between the edge of the effective HTS layer (the edge formed by the striation) and the slit edge of the HTS wire is greater than the maximum positioning error of the slitting process used. For example, where the positioning error of the slitting process is from 10-50 µm, distance 510 can be greater than 50 µm. This ensures that the slit will be formed outside the inner edge of the striation so that the striation will be effective at preventing propagation of mechanical errors.

In one particular non-limiting example, buffer and superconductor layers are deposited onto a 50 µm thick Hastelloy substrate layer that is 12 mm wide. In this specific example, the buffer layer is a buffer stack as described above having a combined thickness of ~ 0.2 µm, while the superconducting layer is a layer of REBCO with a thickness of 1.6 µm. An encapsulating overlayer of silver has been deposited over the entire structure to a thickness of 1.0 µm. The base HTS wire is to be slit along its length to produce three separate HTS wires having a width of approximately 4 mm.

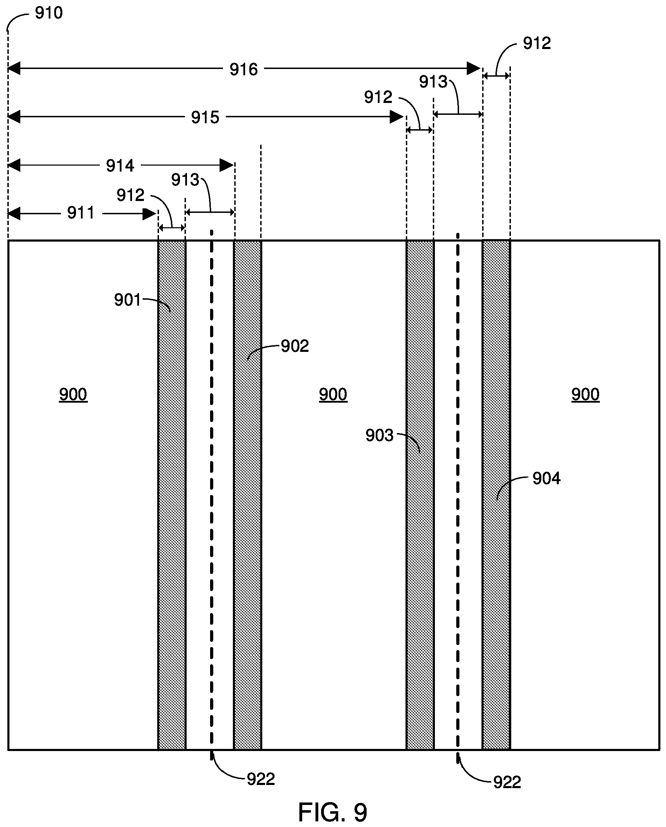

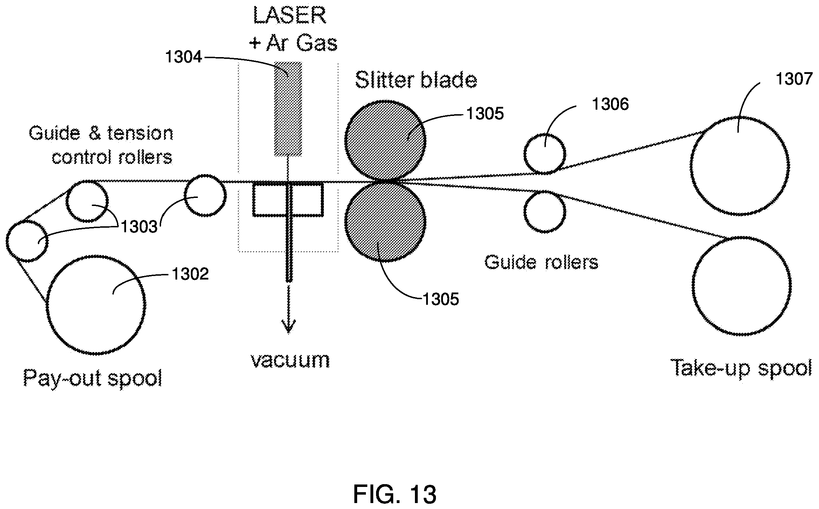

As shown in FIG. 9, four separate striations (901, 902, 903, and 904) are then cut lengthwise into the base HTS wire 900 using a commercially available Femto-second pulse laser. Each striation has a width 912 of approximately 20 µm and a depth of approximately 2 µm. Proceeding from the left-hand side 910 of the base HTS wire shown in FIG. 13, a first striation 901 will be cut so that the distance 911 from the left edge the base HTS wire to the left edge of the first striation is approximately 3.94 mm. A second striation 902 will then be cut so that the distance 914 from the left edge of the base HTS wire to the left edge of the second striation is approximately 4.01 mm. As a result, the distance 913 between the two striations (from the right edge of the first striation to the left edge of the second striation) is approximately 50 µm, A third striation 903 is cut so that the distance 915 from the left edge of the base HTS wire to the left edge of the third striation is approximately 7.97 mm. A fourth striation will then be cut so that the distance 916 from the left edge of the base HTS wire to the left edge of the fourth striation is approximately 8.04 mm. Accordingly, the distance between the right edge of the third striation and the left edge of the fourth striation is also approximately 50 µm,

The base HTS wire will then be slit at positions shown by dashed line 922 to form three final HTS wires 320 of approximately 3.94 mm in width using a mechanical slitter. The slitter will be positioned to slit the base HTS wire through the 50 µm shoulders between the first and second striations and between the third and fourth striations. Given a maximum positional error of the mechanical slitter of ± 15 µm for this example, this insures that the slits will both be separated from the edges of the effective HTS layers resulting from the striations.

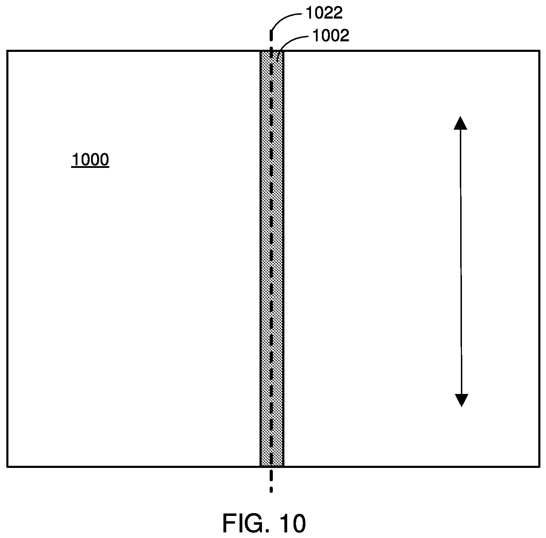

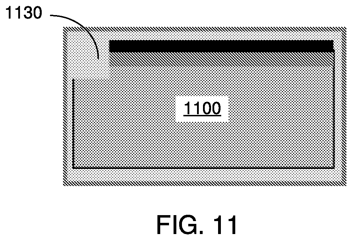

FIG. 10 shows another embodiment of the present invention in which a single striation 1002 is formed (for each desired slit) and then the HTS wire 1000 is slit within the striation as shown by dashed line 1022. As shown in FIG. 11, this results in a structure where the HTS and buffer layers are removed forming a "notch" 1130 at the slit edge of the final HTS wire 1100. A problem with the embodiment of FIGs. 10 and 11 is that it is difficult, if not impossible, to reliably slit the HTS wire within the striation unless a very large striation is used. Mechanical slitting has a positional error of as much as 10-50 µm. Especially for high speed production, it is difficult to ensure that the slit occurs on a narrow striation. Due to positioning error, attempting to slit within the striation will result in a certain number of instances where the actual slitting occurs on or even inside of the striation, thus eliminating any advantage of the striation altogether. Applicants have discovered that the best balancing of the considerations of reliability, production speed, and reduction of wasted HTS wire can be achieved by using a relatively narrow striation width and slitting the wire within the wider shoulder between two striations (or between an outermost striation and the edge of the HTS wire) as described above.

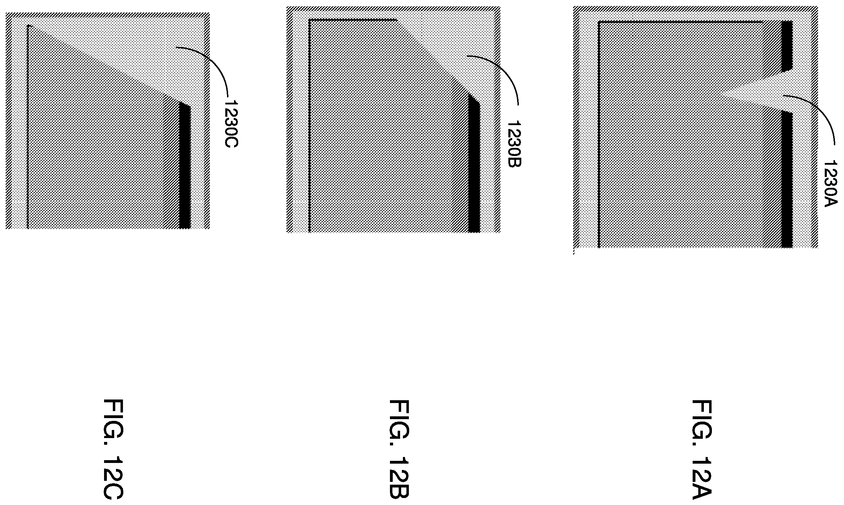

The striations shown in the schematic drawings herein all have a rectangular cross-section for ease of illustration. As will be appreciated by persons of skill in the art, however, the actual shape of the striation will depend to a large degree on the apparatus used to form the striation. For example, a striation cut using a laser will tend to have a rounded base rather than the rectangular shape shown in the drawings. Further, in some embodiments it may be desirable to form a striation with a different cross-sectional shape, such as the V-shaped striation 1230 shown in FIG. 12A or the sloped edge striations (1230B, 1230C) shown in FIG. 12B and FIG. 12C.

FIG. 13 shows schematically an apparatus for forming striations using laser ablation and then using mechanical slitting to separate the base HTS wire into multiple HTS wires with narrower widths. Base HTS wire is wound around pay-out spool 1302 and is fed into apparatus 1300 via guide and tension rollers 1303, As the base HTS wire is fed through the apparatus, one of more lasers 1304 can be used to form a desired number of parallel striations in the base HTS wire. As described above, mechanical slitter blades 1305 can be oriented so that the base HTS wire is slit so that the striations will prevent mechanical damage from spreading into the active HTS layers of the final separated HTS wires. After slitting, final HTS wires can be fed through guide rollers 1306 and rolled onto take-up spools 1307.

The invention described herein has broad applicability and can provide many benefits as described and shown in the examples above. The embodiments will vary greatly depending upon the specific application, and not every embodiment will provide all of the benefits and meet all of the objectives that are achievable by the invention.

Whenever the terms "automatic," "automated," or similar terms are used herein, those terms will be understood to include manual initiation of the automatic or automated process or step. In the discussion and in the claims, the terms "including" and "comprising" are used in an open-ended fashion, and thus should be interpreted to mean "including, but not limited to . . . ." To the extent that any term is not specially defined in this specification, the intent is that the term is to be given its plain and ordinary meaning. The accompanying drawings are intended to aid in understanding the present invention and, unless otherwise indicated, are not drawn to scale. As used herein, the words "right," "left," "lower," "upper," "bottom," "horizontal," "vertical," and the like designate directions in the drawings to which reference is made. These terms are used for convenience only and are not limiting.

Further, it should be recognized that embodiments of the present invention can be implemented via computer hardware or software, or a combination of both. The methods can be implemented in computer programs using standard programming techniquesincluding a computer-readable storage medium configured with a computer program, where the storage medium so configured causes a computer to operate in a specific and predefined manner-according to the methods and figures described in this Specification. Each program may be implemented in a high-level procedural or object-oriented programming language to communicate with a computer system. However, the programs can be implemented in assembly or machine language, if desired. In any case, the language can be a compiled or interpreted language. Moreover, the program can run on dedicated integrated circuits programmed for that purpose.

The scope of the present application is not intended to be limited to the particular embodiments of the process, machine, manufacture, composition of matter, means, methods and steps described in the specification. As one of ordinary skill in the art will readily appreciate from the disclosure of the present invention, processes, machines, manufacture, compositions of matter, means, methods, or steps, presently existing or later to be developed that perform substantially the same function or achieve substantially the same result as the corresponding embodiments described herein may be utilized according to the present invention. The figures described herein are generally schematic and do not necessarily portray the embodiments of the invention in proper proportion or scale.

## Claims

1. A superconducting article (100,800) comprising:
a metal tape substrate (110);
a buffer layer (112) overlying the metal tape substrate;
a superconducting layer (114) overlying the buffer layer;
at least one striation (502, 802, 901-904) running the length of the superconducting article and comprising an area in which most or all of the superconducting and buffer layers are removed but at least a portion of the metal tape substrate remains, **characterized in that** said striation has a width of about 500 µm or less and said striation has an outer edge located between about 10 µm and about 500 nm of an outer edge of the superconducting article.

2. The superconducting article of claim 1 in which the at least one striation running the length of the superconducting article comprises two striations running the length of the superconducting article, the two striations located on opposite sides of the superconducting article.

3. The superconducting article of any of the preceding claims in which the striation has a width of about 200 µm or less, about 100 µm or less, about 50 µm or less, or about 20 µm or less, particularly wherein the striation has a width of about 20 µm.

4. The superconducting article of any of the preceding claims in which the striation has a depth of about 2 µm.

5. The superconducting article of any of the preceding claims in which the striation has a depth that is at least equal to the total thickness of any layers of material deposited on the metal substrate, particularly wherein the striation has a depth that is greater than the total thickness of any layers of material deposited on the metal substrate.

6. A method of forming a superconducting article (100, 800, 900) according to claim 1, the method comprising:
providing a base superconducting article comprising a metal tape substrate (110), a buffer layer (112) overlying the substrate, and a superconducting layer (114) overlying the buffer;
forming at least two substantially parallel striations (502, 802, 901-904) lengthwise along the base superconducting article, said striations comprising two gaps having substantially no superconducting or buffer layers overlying the substrate;
and **characterized by** slitting the base superconducting article lengthwise through its entire thickness in the portion of the base superconducting article between the two striations.

7. The method of claim 6 in which:
the two striations are formed using laser ablation, etching, or ion beam or plasma milling; or
the two striations are formed by patterning the buffer and superconducting layers during deposition so that no buffer or superconductor is deposited within the striations.

8. The method of any one of claims 6 or 7 in which:
slitting the base superconducting article comprises slitting the base superconducting article using a mechanical slitter; or
slitting the base superconducting article comprises slitting the base superconducting article using a laser.

9. The method of any one of claims 6-8 in which slitting the base superconducting article lengthwise comprises slitting the base superconducting article lengthwise so that the distance between the slit and the opposite edges of each of the two substantially parallel striations is greater than the maximum positional error of the slitting process.

10. The method of any one of claims 6-8 in which:
the base superconducting article has a starting width before slitting of at least 12 mm; or
the base superconducting article has a starting width before slitting of 12 mm to 10 cm.

11. The method of any one of claims 6-10 in which the distance between the two parallel striations is approximately 50 micrometers

12. The method of any one of claims 6-11 in which:
slitting the base superconducting article between the at least two parallel striations results in a plurality of final superconducting articles, each having a smaller width than the base superconducting article; or
slitting the base superconducting article between the at least two parallel striations results in a plurality of final superconducting articles, each having the same approximate width.

13. The method of any one of claims 6-12, wherein:
the method further comprises depositing a protective capping layer over the superconducting layer before forming the at least two substantially parallel striations; or
a capping layer is applied over the base superconducting article after forming the at least two substantially parallel striations and before slitting the base superconducting article lengthwise.

14. The method of claim 13 in which the capping layer comprises silver.

15. A method of forming a superconducting article, the method comprising:
providing a base superconducting article (900) comprising a metal tape substrate (110) a buffer layer (112) overlying the substrate, and a superconducting layer (114) overlying the buffer;
forming a first pair of two substantially parallel striations (901-904) lengthwise along the base superconducting article, said striations comprising two gaps having substantially no superconducting or buffer layers overlying the substrate;
forming a second pair of two substantially parallel striations lengthwise along the base superconducting article, said striations comprising two gaps having substantially no superconducting or buffer layers overlying the substrate;
**characterized by** slitting the base superconducting article lengthwise through its entire thickness in the portion of the base superconducting article between the two parallel striations in each pair of substantially parallel striations.

## Patentansprüche

1. Supraleitender Artikel (100, 800), umfassend:
ein Metallbandsubstrat (110);
eine Pufferschicht (112), die über dem Metallbandsubstrat liegt;
eine supraleitende Schicht (114), die über der Pufferschicht liegt;
mindestens eine Streifung (502, 802, 901-904), die sich über die Länge des supraleitenden Artikels erstreckt und einen Bereich umfasst, in dem die meisten oder alle supraleitenden Schichten und Pufferschichten entfernt sind, aber mindestens ein Teil des Metallbandsubstrats verbleibt,
**dadurch gekennzeichnet, dass**
die Streifung eine Breite von etwa 500 µm oder weniger aufweist und die Streifung eine Außenkante aufweist, die zwischen etwa 10 µm und etwa 500 nm von einer Außenkante des supraleitenden Artikels entfernt angeordnet ist.

2. Supraleitender Artikel nach Anspruch 1, wobei die mindestens eine Streifung, die sich über die Länge des supraleitenden Gegenstands erstreckt, zwei Streifungen umfasst, die sich über die Länge des supraleitenden Gegenstands erstrecken, wobei die beiden Streifungen auf gegenüberliegenden Seiten des supraleitenden Gegenstands angeordnet sind.

3. Supraleitender Artikel nach einem der vorstehenden Ansprüche, wobei die Streifung eine Breite von etwa 200 µm oder weniger, etwa 100 µm oder weniger, etwa 50 µm oder weniger oder etwa 20 µm oder weniger aufweist, insbesondere wobei die Streifung eine Breite von etwa 20 µm aufweist.

4. Supraleitender Artikel nach einem der vorstehenden Ansprüche, wobei die Streifung eine Tiefe von etwa 2 µm aufweist.

5. Supraleitender Artikel nach einem der vorstehenden Ansprüche, wobei die Streifung eine Tiefe aufweisen, die mindestens gleich der Gesamtdicke aller auf dem Metallsubstrat abgeschiedenen Materialschichten ist, insbesondere wobei die Streifung eine Tiefe aufweist, die größer ist als die Gesamtdicke aller auf dem Metallsubstrat abgeschiedenen Materialschichten.

6. Verfahren zur Herstellung eines supraleitenden Artikels (100, 800, 900) gemäß Anspruch 1, wobei das Verfahren umfasst:
Bereitstellen eines supraleitenden Basisartikels, der ein Metallbandsubstrat (110), eine über dem Substrat liegende Pufferschicht (112) und eine über der Pufferschicht liegende supraleitende Schicht (114) umfasst;
Ausbilden von mindestens zwei im Wesentlichen parallelen Streifungen (502, 802, 901-904) in Längsrichtung entlang des supraleitenden Basisartikels, wobei die Streifungen zwei Lücken umfassen, die im Wesentlichen keine supraleitenden oder Pufferschichten aufweisen, die über dem Substrat liegen;
und **gekennzeichnet durch**
Schneiden des supraleitenden Basisartikels in Längsrichtung durch seine gesamte Dicke in dem Abschnitt des supraleitenden Basisartikels zwischen den beiden Streifungen.

7. Verfahren nach Anspruch 6, wobei
die beiden Streifungen durch Laserablation, Ätzen oder Ionenstrahl- oder Plasmafräsen gebildet werden; oder
die beiden Streifungen durch Strukturieren der Puffer- und supraleitenden Schichten während des Abscheidens gebildet werden, so dass innerhalb der Streifungen kein Puffer oder Supraleiter abgeschieden wird.

8. Verfahren nach einem der Ansprüche 6 oder 7, wobei
das Schneiden des supraleitenden Basisartikels das Schneiden des supraleitenden Basisartikels unter Benutzung einer mechanischen Schneidvorrichtung umfasst; oder
das Schneiden des supraleitenden Basisartikels das Schneiden des supraleitenden Basisartikels unter Benutzung eines Lasers umfasst.

9. Verfahren nach einem der Ansprüche 6 bis 8, wobei das Längsschneiden des supraleitenden Basisartikels das Längsschneiden des supraleitenden Basisartikels, so dass der Abstand zwischen dem Schnitt und den gegenüberliegenden Kanten jeder der beiden im Wesentlichen parallelen Streifungen größer ist als der maximale Positionsfehler des Schneidvorgangs, umfasst.

10. Verfahren nach einem der Ansprüche 6 bis 8, in dem
der supraleitende Basisartikel vor dem Schneiden eine Ausgangsbreite von mindestens 12 mm aufweist; oder
der supraleitende Basisartikel vor dem Schneiden eine Ausgangsbreite von 12 mm bis 10 cm aufweist.

11. Verfahren nach einem der Ansprüche 6 bis 10, wobei der Abstand zwischen den beiden parallelen Streifungen etwa 50 Mikrometer beträgt.

12. Verfahren nach einem der Ansprüche 6 bis 11, wobei
das Schneiden des supraleitenden Basisartikels zwischen den mindestens zwei parallelen Streifungen zu einer Vielzahl von endgültigen supraleitenden Artikeln führt, die jeweils eine geringere Breite als der supraleitende Basisartikel aufweisen; oder
das Schneiden des supraleitenden Basisartikels zwischen den mindestens zwei parallelen Streifungen zu einer Vielzahl von endgültigen supraleitenden Artikeln führt, die jeweils ungefähr die gleiche Breite aufweisen.

13. Verfahren nach einem der Ansprüche 6 bis 12, wobei
das Verfahren ferner das Abscheiden einer schützenden Deckschicht über der supraleitenden Schicht vor dem Ausbilden der mindestens zwei im Wesentlichen parallelen Streifungen umfasst; oder
eine Deckschicht über den supraleitenden Basisartikel nach dem Ausbilden der mindestens zwei im Wesentlichen parallelen Streifungen und vor dem Längsschneiden des supraleitenden Basisartikels aufgebracht wird.

14. Verfahren nach Anspruch 13, wobei die Deckschicht Silber umfasst.

15. Verfahren zur Herstellung eines supraleitenden Artikels, wobei das Verfahren umfasst:
Bereitstellen eines supraleitenden Basisartikels (900), der ein Metallbandsubstrat (110), eine über dem Substrat liegende Pufferschicht (112) und eine über der Pufferschicht liegende supraleitende Schicht (114) umfasst;
Ausbilden eines ersten Paares von zwei im Wesentlichen parallelen Streifungen (901-904) in Längsrichtung entlang des supraleitenden Basisartikels, wobei die Streifungen zwei Lücken umfassen, die im Wesentlichen keine supraleitenden oder Pufferschichten aufweisen, die über dem Substrat liegen;
Bilden eines zweiten Paares von zwei im Wesentlichen parallelen Streifungen in Längsrichtung entlang des supraleitenden Basisartikels, wobei die Streifungen zwei Lücken umfassen, die im Wesentlichen keine supraleitenden oder Pufferschichten aufweisen, die über dem Substrat liegen;
**gekennzeichnet durch**
Schneiden des supraleitenden Basisartikels in Längsrichtung durch seine gesamte Dicke in dem Abschnitt des supraleitenden Basisartikels zwischen den zwei parallelen Streifungen in jedem Paar von im Wesentlichen parallelen Streifungen.

## Revendications

1. Article supraconducteur (100, 800) comprenant :
un substrat en bande métallique (110) ;
une couche tampon (112) recouvrant le substrat en bande métallique ;
une couche supraconductrice (114) recouvrant la couche tampon ;
au moins une strie (502, 802, 901-904) s'étendant sur toute la longueur de l'article supraconducteur et comprenant une zone dans laquelle la plus grande partie ou la totalité des couches supraconductrice et tampon est retirée, mais au moins une partie du substrat en bande métallique demeure, **caractérisée en ce que** ladite strie a une largeur d'environ 500 µm ou moins et ladite strie a un bord extérieur situé entre environ 10 µm et environ 500 nm d'un bord extérieur de l'article supraconducteur.

2. Article supraconducteur selon la revendication 1, dans lequel la ou les stries s'étendant sur toute la longueur de l'article supraconducteur comprennent deux stries s'étendant sur toute la longueur de l'article supraconducteur, les deux stries étant situées de part et d'autre de l'article supraconducteur.

3. Article supraconducteur selon l'une quelconque des revendications précédentes, dans lequel la strie a une largeur d'environ 200 µm ou moins, d'environ 100 µm ou moins, d'environ 50 µm ou moins, ou d'environ 20 µm ou moins, en particulier dans lequel la strie a une largeur d'environ 20 µm.

4. Article supraconducteur selon l'une quelconque des revendications précédentes, dans lequel la strie a une profondeur d'environ 2 µm.

5. Article supraconducteur selon l'une quelconque des revendications précédentes, dans lequel la strie a une profondeur qui est au moins égale à l'épaisseur totale de toutes les couches de matériau déposées sur le substrat métallique, en particulier dans lequel la strie a une profondeur qui est supérieure à l'épaisseur totale de toutes les couches de matériau déposées sur le substrat métallique.

6. Procédé de formation d'un article supraconducteur (100, 800, 900) selon la revendication 1, le procédé comprenant :
la fourniture d'un article supraconducteur de base comprenant un substrat en bande métallique (110), une couche tampon (112) recouvrant le substrat et une couche supraconductrice (114) recouvrant le tampon ;
la formation d'au moins deux stries sensiblement parallèles (502, 802, 901-904) dans le sens de la longueur de l'article supraconducteur de base, lesdites stries comprenant deux espaces sensiblement dépourvus de couches supraconductrice ou tampon recouvrant le substrat ;
et **caractérisé par** le fendage longitudinal de l'article supraconducteur de base sur toute son épaisseur, dans la partie de l'article supraconducteur de base située entre les deux stries

7. Procédé selon la revendication 6, dans lequel :
les deux stries sont formées par ablation laser, gravure, ou fraisage par faisceau d'ions ou plasma ; ou
les deux stries sont formées par la structuration des couches tampon et supraconductrice pendant le dépôt, de sorte qu'aucun tampon ni supraconducteur ne soit déposé à l'intérieur des stries.

8. Procédé selon l'une quelconque des revendications 6 ou 7, dans lequel :
le fendage de l'article supraconducteur de base comprend le fendage de l'article supraconducteur de base à l'aide d'une découpeuse mécanique ; ou
le fendage de l'article supraconducteur de base comprend le fendage de l'article supraconducteur de base à l'aide d'un laser.

9. Procédé selon l'une quelconque des revendications 6 à 8, dans lequel le fendage longitudinal de l'article supraconducteur de base comprend le fendage longitudinal de l'article supraconducteur de base de telle sorte que la distance entre la fente et les bords opposés de chacune des deux stries sensiblement parallèles soit supérieure à l'erreur maximale de positionnement du procédé de fendage.

10. Procédé selon l'une quelconque des revendications 6 à 8, dans lequel :
l'article supraconducteur de base a une largeur initiale avant fendage d'au moins 12 mm ; ou
l'article supraconducteur de base a une largeur initiale avant fendage de 12 mm à 10 cm.

11. Procédé selon l'une quelconque des revendications 6 à 10, dans lequel la distance entre les deux stries parallèles est d'environ 50 micromètres.

12. Procédé selon l'une quelconque des revendications 6 à 11, dans lequel :
le fendage de l'article supraconducteur de base entre les au moins deux stries parallèles produit une pluralité d'articles supraconducteurs finaux, ayant chacun une largeur inférieure à celle de l'article supraconducteur de base ; ou
le fendage de l'article supraconducteur de base entre les au moins deux stries parallèles produit une pluralité d'articles supraconducteurs finaux, ayant chacun approximativement la même largeur.

13. Procédé selon l'une quelconque des revendications 6 à 12, dans lequel :
le procédé comprend en outre le dépôt d'une couche de recouvrement protectrice sur la couche supraconductrice avant la formation des au moins deux stries sensiblement parallèles ; ou
une couche de recouvrement est appliquée sur l'article supraconducteur de base après la formation des au moins deux stries sensiblement parallèles et avant le fendage longitudinal de l'article supraconducteur de base.

14. Procédé selon la revendication 13, dans lequel la couche de recouvrement comprend de l'argent.

15. Procédé de formation d'un article supraconducteur, le procédé comprenant :
la fourniture d'un article supraconducteur de base (900) comprenant un substrat en bande métallique (110) : une couche tampon (112) recouvrant le substrat et une couche supraconductrice (114) recouvrant le tampon ;
la formation d'une première paire de deux stries sensiblement parallèles (901-904) longitudinalement le long de l'article supraconducteur de base, lesdites stries comprenant deux espaces sensiblement dépourvus de couches supraconductrice ou tampon recouvrant le substrat ;
la formation d'une seconde paire de deux stries sensiblement parallèles longitudinalement le long de l'article supraconducteur de base, lesdites stries comprenant deux espaces sensiblement dépourvus de couches supraconductrice ou tampon recouvrant le substrat ;
**caractérisé par** le fendage longitudinal de l'article supraconducteur de base sur toute son épaisseur, dans la partie de l'article supraconducteur de base située entre les deux stries parallèles de chaque paire de stries sensiblement parallèles.
